# EUROPÄISCHE PATENTSCHRIFT

(11) **EP 2 561 737 B1**
(45) Veröffentlichungstag und Bekanntmachung des Hinweises auf die Patenterteilung: **08.07.2015**
(21) Anmeldenummer: 11708279.2
(22) Anmeldetag: 15.03.2011
(51) Int. Cl.: F04D 29/54, F04D 29/60, H05K 7/20

(54) **LUFTFÜHRUNGSEINHEIT**
AIR GUIDANCE UNIT
UNITÉ DE GUIDAGE D'AIR

(30) Priorität: 19.04.2010 DE 102010016503
(43) Veröffentlichungstag der Anmeldung: 27.02.2013
(73) Patentinhaber: RITTAL GmbH & Co. KG, 35745 Herborn (DE)
(72) Erfinder: HARTMANN, Reiner, 35435 Wettenberg (DE)
(74) Vertreter: Angerhausen, Christoph
(86) Internationale Anmeldenummer: PCT/EP2011/053891
(87) Internationale Veröffentlichungsnummer: WO 2011/131423

(56) Entgegenhaltungen:
- EP-A1- 0 242 342
- EP-A1- 2 338 581
- WO-A1-2010/138327
- WO-A2-2007/090804
- DE-U1-202006 015 789
- US-A- 5 117 656
- US-A1- 2008 037 216

## Beschreibung

Die Erfindung betrifft eine Luftführungseinheit für den Einbau ein einem Ausschnitt einer Schaltschrankwand mit einem Luftführungsgehäuse und einer damit lösbar verbindbaren Ventilatorbaugruppe, wobei das Luftführungsgehäuse einen oder mehrere Sperransätzeund die Ventilatorbaugruppe Verschlussaufnahmen mit einem Blockierabschnitt, in den der Sperransatz einschwenkbar ist, aufweist, wobei in der Montagestellung der Ventilatorbaugruppe ein lösbares Arretierstück die Ventilatorbaugruppe unverstellbar festlegt, wobei die Ventilatorbaugruppe zwei Befestigungsseiten aufweist, die jeweils die Verschlussaufnahmen mit dem Blockierabschnitt aufweisen, wobei die Ventilatorbaugruppe mittels der beiden Befestigungsseiten wahlweise in um 180° verdrehten Betriebsstellungen an dem Luftfiihrungsgehäuse festlegbar ist und ein Gehäuse aufweist, das zwei Flansche aufweist, die mit den Verschlussaufnahmen ausgerüstet sind, und wobei die Ventilatorbaugruppe zur Montage abhängig von einer gewünschten Betriebsart, saugend oder blasend, mit dem entsprechenden Flansch rückseitig auf einen Boden des Luftführungsgehäuses aufgesetzt ist, so dass die Luftführungseinheit wahlweise von einem saugenden auf einen blasenden Betrieb, und umgekehrt, umgerüstet werden kann. Eine derartige Luftführungseinheit ist aus der nachveröffentlichten EP 2 338 581 A1 bekannt.

Im Wartungsfall muss lediglich das Arretierstück entriegelt werden. Dann lässt sich die Ventilatorbaugruppe von dem Sperransatz abschwenken und kann abgenommen werden. Eine neue Ventilatorbaugruppe kann dann in umgekehrter Montagereihenfolge schnell und einfach ersetzt werden. Ähnliche Luftführungseinheiten beschreibt auch die WO 2007/090804 A2, die US 5,117,656 A, die EP 0 242 342 A1, die US 2008/037216 A1 und die DE 20 2006 015 789 U1 bekannt.

Solche Luftführungseinheiten werden zum Beispiel im Schaltschrankbau eingesetzt. Dabei wird das Luftführungsgehäuse in einen Ausschnitt einer Schaltschrankwand eingebaut. Die Ventilatorbaugruppe umfasst in der Regel einen Elektromotor und einen Ventilator, der Umgebungsluft ansaugt, durch das Luftfiihrungsgehäuse fördert und in den Innenraum des Schaltschrankes einbläst. In einer alternativen Bauvariante ist die Luftförderrichtung umgekehrt, wobei Luft aus dem Schaltschrankinnenraum abgesaugt und über das Luftführungsgehäuse in die Umgebung ausgeblasen wird. Im Wartungsfall wird die defekte Ventilatorbaugruppe von dem Luftführungsgehäuse getrennt und gegen eine neue ausgetauscht.

Es ist die Aufgabe der Erfindung, eine Luftfiihrungseinheit der eingangs erwähnten Art bereit zu stellen, welche die komfortable Wartung der Ventilatorbaugruppe erlaubt.

Bei der erfindungsgemäßen Luftführungseinheit trägt das Luftfiihrungsgehäuse frontseitig Scharnierteile, an denen ein Luftführungsgitter schwenkbar anscharniert ist, so dass das Luftführungsgitter zwischen einer Montage- und Wartungsposition verschwenkbar ist, wobei es in der Montageposition frontseitig einen Luftdurchtrittsbereich des Luftführungsgehäuses überdeckt. Über die Scharnierverbindung ist das Luftführungsgitter insbesondere zu Wartungsarbeiten gegenüber dem Luftführungsgehäuse abklappbar und in der abgeklappten Stellung unverlierbar gehalten. Damit muss das Wartungspersonal das Luftführungsgitter nicht gesichert zur Seite legen, wodurch die Wartung weiter vereinfacht wird. In dem Luftführungsgitter oder in dem Luftführungsgehäuse kann eine Filtermatte eingesetzt sein, die bei der Wartung getauscht wird. Nach der erfolgten Wartung kann das Luftführungsgitter einfach übe die Scharnierverbindung wieder in seine Montageposition verschwenkt werden.

Gemäß einer bevorzugten Ausgestaltungsvariante der Erfindung kann es vorgesehen sein, dass die Ventilatorbaugruppe einen Stromanschluss aufweist, dass die Ventilatorbaugruppe in mehrere Montagepositionen an dem Luftführungsgehäuse festlegbar ist, und dass der Stromanschluss in den unterschiedlichen Montagepositionen in verschiedene Zuordnungen zum Luftführungsgehäuse orientiert ist. Die Verriegelungsmechanik zwischen der Ventilatorbaugruppe und dem Luftführungsgehäuse ermöglicht somit eine individuelle Ausrichtung des Stromanschlusses auf die Einbaugegebenheiten im Schaltschrank.

Eine erfindungsgemäße Luftführungseinheit kann dadurch gekennzeichnet sein, dass die Ventilatorbaugruppe einen kreisförmigen Bund aufweist, der in eine kreisförmige Durchtrittsöffnung des Luftführungsgehäuses eingesetzt und darin zentriert ist, und dass der Bund zum Einschwenken des Sperransatzes in den Blockierabschnitt in der Durchtrittsöffnung verdrehbar ist. Die Zuordnung des kreisförmigen Bundes und der Durchtrittsöffnung bildet eine Art Lager, die die Schwenkbewegung der Ventilatorbaugruppe führt. Damit ist auch bei beengten oder unübersichtlichen Einbauverhältnissen stets eine zielgerichtete und einfache Montage möglich.

Eine werkzeuglose Montage der Ventilatorbaugruppe an dem Luftführungsgehäuse gelingt auf einfache Weise dann, wenn vorgesehen ist, dass das Arretierstück gegen die Vorspannung einer Feder beim Einschwenken der Ventilatorbaugruppe auslenkbar ist und dass das Arretierstück in der Montagestellung in eine Rastaufnahme zur Arretierung der Ventilatorbaugruppe einschnappt.

Zum Lösen der Ventilatorbaugruppe wird das Arretierstück einfach gegen die Federvorspannung ausgelenkt, so dass es außer Eingriff mit der Rastaufnahme gelangt. Dann ist die Ventilatorbaugruppe freigegeben und kann ausgeschwenkt werden.

Die Betätigung des Arretierstückes wird insbesondere dadurch erleichtert, dass es mittels eines Auslöseteils in der Montagestellung der Ventilatorbaugruppe aus seiner Arretierstellung in eine Entriegelungsstellung bewegbar ist.

Eine bevorzugte Erfindungsvariante ist dergestalt, dass das Luftführungsgehäuse eine umlaufende Gehäusewand aufweist, die mit einem Boden einteilig verbunden ist, dass der Boden die Durchtrittsöffnung für die von der Ventilatorbaugruppe geförderte Luft aufweist, und dass im Bereich der Gehäusewand außenseitig Rastelemente zur Verrastung des Luftführungsgehäuses in einem Durchbruch eines Wandelementes des Schaltschrankes aufweist. Über die Rastelemente kann eine werkzeuglose Fixierung der Luftführungseinheit am Schaltschrank erreicht werden. Alternativ oder zusätzlich kann auch, wenn dies gewünscht wird, eine Verschraubung der Luftführungseinheit mit dem Wandelement des Schaltschrankes vorgesehen sein.

Wenn vorgesehen ist, dass der Sperransatz knopfartig ausgebildet ist und einen Schaft aufweist, der an seinem freien Ende einen Kopf trägt, und dass der Blockierabschnitt als schlitzförmige Aufnahme ausgebildet ist, der den Schaft aufnimmt und von dem Kopf übergriffen ist, dann wird eine stabile Festlegung der Ventilatorbaugruppe mit geringem baulichen Aufwand möglich.

Die Erfindung wird im Folgenden anhand eines in den Zeichnungen dargestellten Ausführungsbeispiels näher erläutert.

Es zeigen:
- Fig. 1: in perspektivischer Frontansicht ein Luftführungsgehäuse einer Luftührungseinheit,
- Fig. 2: in Explosionsdarstellung das Luftführungsgehäuse gemäß Fig. 1 in Rückansicht sowie eine Ventilatorbaugruppe.

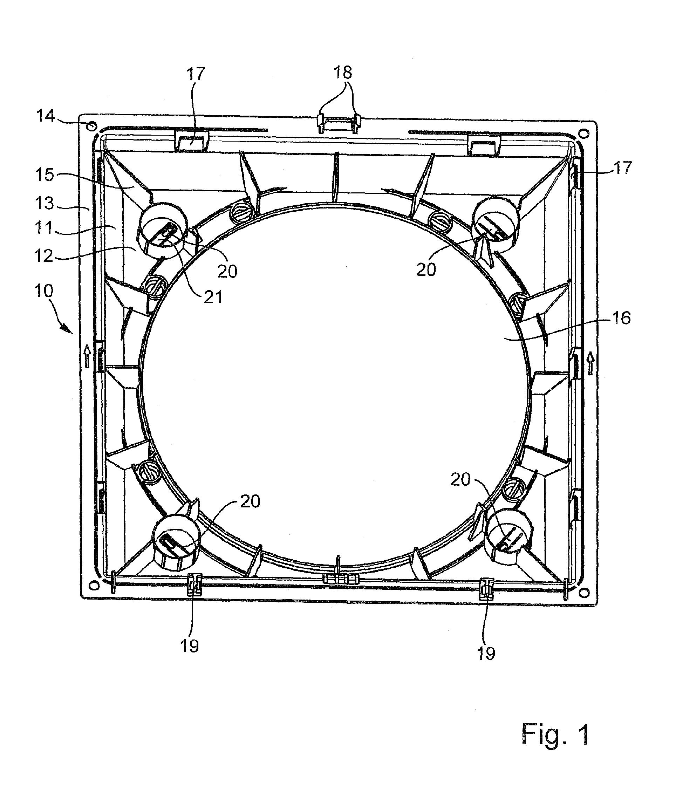

Fig. 1 zeigt ein Luftführungsgehäuse 10, das eine umlaufende Gehäusewand 11 aufweist. An diese Gehäusewand 11 schließt sich ein Boden 12 an, der von einer kreisrunden Durchtrittsöffnung 16 durchdrungen ist. Der Boden 12 ist aus Stabilitätsgründen mittels Stegen 15 an die Gehäusewand 11 angekoppelt. Die Gehäusewand 11 schließt dem Boden 12 abgekehrt mit einem umlaufenden Bund 13 ab, der radial nach außen gerichtet ist. In den Bund 13 sind in den Eckbereichen Schraubaufnahmen 14 eingebracht. Am unteren horizontalen Rand des Bundes 13 sind zwei Scharnierteile 19 angeformt. An diesen Scharnierteilen 19 kann ein, in den Zeichnungen nicht dargestelltes, Luftführungsgitter anscharniert werden. Das Luftführungsgitter lässt sich um eine horizontale Schwenkachse abklappen. In der Montageposition kann das Luftführungsgitter an einem Riegel 18 festgelegt werden, der im oberen Bereich des Bundes 13 angeordnet ist.

Die in Fig. 1 gezeigte Baueinheit ist einteilig als Kunststoff-Spritzgussteil ausgeführt.

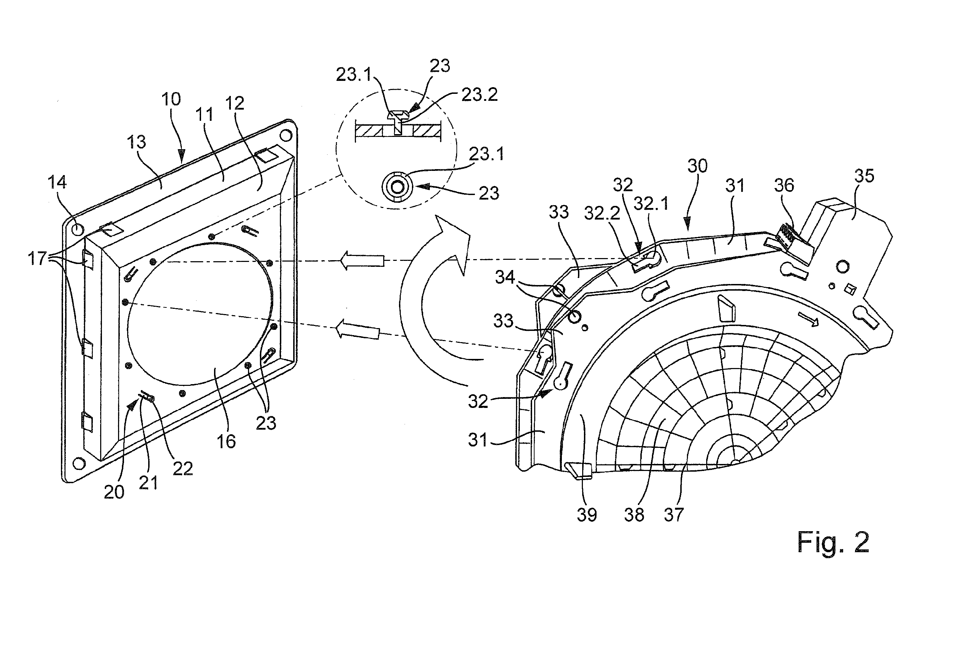

In den Eckbereichen des Luftführungsgehäuses 10 sind Sperrelemente 20 angeordnet, die in Form von Zungen aus dem Boden 12 freigestellt sind. Die Sperrelemente 20 sind über ein Koppelstück, das als Feder 21 ausgebildet ist, einteilig an den Boden 12 angeformt. Die Feder 21 trägt an ihrem freien Ende ein Arretierstück 22, wie dies die Fig. 2 näher zeigt. Wie aus dieser Darstellung ersichtlich ist, ist das Arretierstück 22 als verdickter Ansatz ausgeformt, der rückseitig über den Boden 12 vorsteht. Auf der Rückseite des Bodens 12 stehen weiterhin Sperransätze 23 vor. In der Kreisdarstellung in Fig. 2 ist die Ausgestaltung des Sperransatzes 23 näher detailliert, wobei die obere Detaildarstellung im Kreis einen Vollschnitt durch den Sperransatz 23 und die untere Darstellung eine Draufsicht auf den Sperransatz 23 darstellt. Wie diese Zeichnungen erkennen lassen, weist der Sperransatz 23 einen Schaft 23.2 auf, der einteilig an den Boden 12 angeformt ist. An dem, dem Boden 12 abgewandten Ende des Schafts 23.2 weist der Sperransatz 23 einen verdickten Kopf 23.1 auf. Aus Entformungsgründen ist unterhalb des Kopfes 23.1 der Boden 12 durch einen Durchbruch freigestellt.

Fig. 2 lässt weiterhin erkennen, dass die Gehäusewand 11 des Luftführungsgehäuses 10 außenseitig vorstehende Rastelemente 17 trägt. Mit diesen Rastelementen 17 kann das Luftführungsgehäuse 10 in einem Durchbruch einer Schaltschrankwand verrastet und damit festgelegt werden. Zusätzlich kann das Luftführungsgehäuse 10 auch noch über die Schraubaufnahmen 14 mit dem Wandelement des Schaltschrankes verschraubt werden.

An dem schaltschrankseitig montierten Luftführungsgehäuse 10 kann eine Ventilatorbaugruppe 30 befestigt werden. Die Ventilatorbaugruppe 30 weist einen integrierten Elektromotor und einen Ventilator 38 auf. Der Elektromotor wird über einen seitlichen Stromanschluss 35 mit einer Anschlussklemme 36 mit Strom versorgt beziehungsweise angesteuert. Der Ventilator 38 ist mittels eines Gitters 37 berührungsgeschützt. Das Gitter 37 ist in einen kreisrunden Bund 39 eingesetzt. Die Ventilatorbaugruppe 30 umfasst ein Gehäuse, das zwei Flansche 31 aufweist. Die Flansche 31 sind mit schlüssellochförmigen Verschlussaufnahmen 32 ausgerüstet. Diese Verschlussaufnahmen 32 weisen eine kreisrunde Aufnahme 32.1 auf, die in einen schlitzförmigen Blockierabschnitt 32.1 übergeht. Beide Flansche 31 sind jeweils an gegenüberliegenden Seiten mit identischen Verschlussaufnahmen 32 ausgerüstet, wobei jedoch die Verschlussaufnahmen 32 spiegelbildlich verdreht positioniert sind. An den Flanschen 31 sind weiterhin Ansätze 33 angeformt, die ein handbedienbares Auslöseteil 34 umfassen. Das Auslöseteil 34 ist über einen Federabschnitt einteilig an den Flansch 31 angeformt und kann gegen die Federvorspannung relativ zum Flansch 31 und senkrecht zur Flanschebene verschwenkt werden. Zur Montage der Ventilatorbaugruppe 30 wird diese, abhängig von der gewünschten Betriebsart (saugender oder blasender Betrieb) mit dem jeweiligen Flansch 31 auf den Boden 12 des Luftführungsgehäuses 10 rückseitig aufgesetzt. Dabei greifen die Köpfe 23.1 der Sperransätze 23 durch die Aufnahmen 32.1 der Verschlussaufnahmen 32 hindurch. Die in der Fig. 2 dargestellten Linearpfeile symbolisieren diese Aufsetzbewegung. Anschließend wird, wie dies die bogenförmige Pfeildarstellung in Fig. 2 veranschaulicht, die Ventilatorbaugruppe 30 im Uhrzeigersinn verdreht. Dabei wird die Ventilatorbaugruppe 30 mit ihren Blockierabschnitten 32.2 über die Schäfte 23.2 der Sperransätze 23 geschoben. Die Köpfe 23.1 der Sperransätze 23 verhindern nun, dass die Ventilatorbaugruppe 30 senkrecht zum Boden 12 abgenommen werden kann. Während der Einschwenkbewegung gleiten die Sperrelemente 20 auf den zugekehrten Seiten des Ansatzes 33 auf und werden dabei federelastisch ausgelenkt. Sobald die Arretierstücke 22 der Sperrelemente 20 in Deckung mit den Auslöseteilen 34 gelangen, schnappen sie in Ausnehmungen des Ansatzes 33 ein, die unterhalb der Auslöseteile 34 angeordnet sind. Auf diese Weise wird dann die Ventilatorbaugruppe 30 unverdrehbar am Luftführungsgehäuse 10 festgelegt. Bei der Verdrehung der Ventilatorbaugruppe 30 gegenüber dem Luftführungsgehäuse 10 greift der Bund 39 in die Durchtrittsöffnung 16 ein. Dabei ist der Außendurchmesser des Bundes 39 angepasst auf den Innendurchmesser der Durchtrittsöffnung 16 ausgelegt, so dass eine Schwenklagerung gebildet ist, die die Schwenkbewegung führt.

Für eine Demontage der Ventilatorbaugruppe 30 werden die Auslöseteile 34 gegen ihre Federvorspannung ausgelenkt und auf die Arretierstücke 22 aufgepresst. Die Auslöseteile 34 können dabei einfach manuell betätigt werden. Beim Aufpressen auf die Arretierstücke 22 werden diese aus den Ausnehmungen ausgelenkt und geben somit die Ventilatorbaugruppe 30 frei. Anschließend kann die Ventilatorbaugruppe 30 entgegen dem Uhrzeigersinn verdreht werden, so dass die Sperransätze 23 in den Bereich der Aufnahmen 32.1 gelangen. Dann kann die Ventilatorbaugruppe 30 senkrecht zum Boden 12 vom Luftführungsgehäuse 10 abgenommen werden und bedarfsweise gegen eine neue Ventilatorbaugruppe 30 ausgetauscht.

## Patentansprüche

1. Luftfiihrungseinheit für den Einbau ein einem Ausschnitt einer Schaltschrankwand mit einem Luftfiihrungsgehäuse (10) und einer damit lösbar verbindbaren Ventilatorbaugruppe, wobei das Luftführungsgehäuse (10) einen oder mehrere Sperransätze (23) und die Ventilatorbaugruppe (30) Verschlussaufnahmen (32) mit einem Blockierabschnitt (32.2), in den der Sperransatz (23) einschwenkbar ist, aufweist, wobei in der Montagestellung der Ventilatorbaugruppe (30) ein lösbares Arretierstück (22) die Ventilatorbaugruppe (30) unverstellbar festlegt, wobei die Ventilatorbaugruppe (30) zwei Befestigungsseiten aufweist, die jeweils die Verschlussaufnahmen (32) mit dem Blockierabschnitt (32.2) aufweisen, wobei die Ventilatorbaugruppe (30) mittels der beiden Befestigungsseiten wahlweise in um 180° verdrehten Betriebsstellungen an dem Luftfiihrungsgehäuse (10) festlegbar ist und ein Gehäuse aufweist, das zwei Flansche (31) aufweist, die mit den Verschlussaufnahmen (32) ausgerüstet sind, und wobei die Ventilatorbaugruppe (30) zur Montage abhängig von einer gewünschten Betriebsart, saugend oder blasend, mit dem entsprechenden Flansch (31) rückseitig auf einen Boden des Luftführungsgehäuses (10) aufgesetzt ist, so dass die Luftführungseinheit wahlweise von einem saugenden auf einen blasenden Betrieb, und umgekehrt, umgerüstet werden kann,
wobei das Luftfiihrungsgehäuse (10) weiterhin frontseitig Scharnierteile (19) trägt, an denen ein Luftführungsgitter schwenkbar anscharniert ist, so dass das Luftführungsgitter zwischen einer Montage- und einer Wartungsposition verschwenkbar ist, wobei es in der Montageposition frontseitig einen Luftdurchtrittsbereich des Lüftführungsgehäuses (10) überdeckt.

2. Luftführungseinheit nach Anspruch 1 ,
**dadurch gekennzeichnet, dass**
die Ventilatorbaugruppe (30) einen Stromanschluss (35) aufweist,
dass die Ventilatorbaugruppe (30) in mehreren Montagepositionen an dem Luftführungsgehäuse (10) festlegbar ist, und
der Stromanschluss (35) in den unterschiedlichen Montagepositionen in verschiedenen Zuordnungen zum Luftführungsgehäuse orientiert ist.

3. Luftführungseinheit nach Anspruch 1 oder 2,
**dadurch gekennzeichnet, dass**
die Ventilatorbaugruppe (30) einen kreisförmigen Bund (39) aufweist, der in eine kreisförmige Durchtrittsöffnung (16) des Luftfiihrungsgehäuses (10) eingesetzt und darin zentriert ist, und
der Bund (39) zum Einschwenken des Sperransatzes (23) in den Blockierabschnitt (32.2) in der Durchtrittsöffnung (16) verdrehbar ist.

4. Luftführungseinheit nach einem der Ansprüche 1 bis 3,
**dadurch gekennzeichnet, dass**
das Arretierstück (22) gegen die Vorspannung einer Feder (21) beim Einschwenken der Ventilatorbaugruppe (30) auslenkbar ist, und
das Arretierstück (22) in der Montagestellung in eine Rastaufnahme zur Arretierung der Ventilatorbaugruppe (30) einschnappt.

5. Luftführungseinheit nach einem der Ansprüche 1 bis 4,
**dadurch gekennzeichnet, dass**
das Arretierstück (22) mittels eines Auslöseteils (34) in der Montagestellung der Ventilatorbaugruppe (30) aus seiner Arretierstellung in eine Entriegelungsstellung bewegbar ist.

6. Luftführungseinheit nach einem der Ansprüche 1 bis 5,
**dadurch gekennzeichnet, dass**
das Luftführungsgehäuse (10) eine umlaufende Gehäusewand (11) aufweist, die mit einem Boden (12) einteilig verbunden ist,
der Boden (12) die Durchtrittsöffnung (16) für die von der Ventilatorbaugruppe (30) geförderte Luft aufweist, und
im Bereich der Gehäusewand (11) außenseitig Rastelemente (17) zur Verrastung des Luftführungsgehäuses (10) in einem Durchbruch eines Wandelementes aufweist.

7. Luftführungseinheit nach einem der Ansprüche 1 bis 6,
**dadurch gekennzeichnet, dass**
der Sperransatz (23) knopfartig ausgebildet ist und einen Schaft (23.2) aufweist, der an seinem freien Ende einen Kopf (23.1) trägt, und
der Blockierabschnitt (32.2) als schlitzförmige Aufnahme ausgebildet ist, der den Schaft (23.2) aufnimmt und von dem Kopf (23.1) übergriffen ist.

## Claims

1. An air guidance unit for mounting into a cut-out of a switchgear cabinet wall, comprising an air guidance housing (10) and a fan assembly that can be detachably connected thereto, the air guidance housing (10) comprising one or more blocking studs (23), the fan assembly (30) comprising closure receptions (32) each having a blocking section (32.2) into which the blocking stud (23) can be swiveled, a detachable locking piece (22) immobilizing the fan assembly (30) in the mounting position of the fan assembly (30),
wherein the fan assembly (30) comprises two fixing sides, the fixing sides comprising the closure receptions (32) with blocking section (23.2) and wherein the fan assembly (30) can be selectively fixed at the air guidance housing (10) by means of the fixing sides in operating positions rotated by 180°, and wherein the fan assembly (30) comprises a housing having two flanges (31) which are equipped with the closure receptions (32) and
wherein the fan assembly (30), depending on a desired operation mode, sucking or blowing, is seated with the respective flange (31) at its rear side on a bottom of the air guidance housing (10), so that the air guidance unit can be selectively converted from sucking to blowing operation and vice versa, wherein the air guidance housing (10) carries hinge parts (19) at a front side thereof to which an air guidance grating is pivotally hinged, so that the air guidance grating can be swiveled between a mounting and a maintenance position, wherein it covers an air passage portion of the air guidance housing (10) at the front thereof in said mounting position.

2. The air guidance unit of claim 1, **characterized in that** the fan assembly (30) comprises a power connection (35), that the fan assembly (30) can be fixed at the air guidance housing (10) in several mounting positions and that the power connection (35) is oriented in different allocations to the air guidance housing in different mounting positions.

3. The air guidance unit of claim 1 or 2, **characterized in that** the fan assembly (30) comprises a circular flange (39) which is inserted into a circular passage (16) of the air guidance housing (10) and centered therein and that the flange (39) can be rotated in the passage (16) to swivel the blocking stud (23) into the blocking section (32.2).

4. The air guidance unit of any of claims 1 to 3, **characterized in that** the locking piece (22) can be deflected against the biasing force of a spring (21) when swiveling the fan assembly (30) and that the locking piece (22) snaps into a snap-lock for locking the fan assembly (30) in the mounting position.

5. The air guidance unit of any of claims 1 to 4, **characterized in that** the locking piece (22) can be moved, in the mounting position of the fan assembly (30), from its locking position into a release position by means of a release piece (34).

6. The air guidance unit of any of claims 1 to 5, **characterized in that** the air guidance housing (10) comprises a continuous housing wall (11) which is integrally connected with a bottom (12), that the bottom (12) comprises the passage (16) for air delivered by the fan assembly (30) and that in the region of the housing wall (11) at the outside thereof snap elements (17) are provided for locking the air guidance housing (10) in an opening of a wall element.

7. The air guidance unit of any of claims 1 to 6, **characterized in that** the blocking stud (23) is shaped like a knob and has a shaft (23.2) carrying a head (23.1) at a free end thereof and that the blocking section (32.2) is formed as a slitshaped receptacle receiving the shaft (23.2) and being overlapped by the head (23.1).

## Revendications

1. Unité de guidage d'air pour le montage dans une découpe d'une paroi d'une armoire de commande, comportant un carter de guidage d'air (10) et un module de ventilateur relié à celui-ci de manière amovible, le carter de guidage d'air (10) comportant une ou plusieurs saillies d'arrêt (23) et le module de ventilateur (30) comportant des logements de verrouillage (32) avec un tronçon de blocage (32.2) dans lequel peut s'engager la saillie d'arrêt (23), une pièce d'immobilisation (22) amovible fixant de manière immobile le module de ventilateur (30) dans la position de montage du module de ventilateur (30), ledit module de ventilateur (30) comportant deux côtés de fixation qui comportent chacun les logements de verrouillage (32) avec le tronçon de blocage (32.2), ledit module de ventilateur (30) pouvant être fixé sur le carter de guidage d'air (10) par l'intermédiaire des deux côtés de fixation, au choix, dans des positions de service tournées de 180°, et comportant un carter qui comprend deux joues (31) qui sont munies des logements de verrouillage (32), et ledit module de ventilateur (30), en vue du montage en fonction d'un mode de fonctionnement souhaité, mode aspiration ou mode soufflage, étant posé avec la face arrière de la joue (31) correspondante sur un fond du carter de guidage d'air (10), de telle sorte que l'unité de guidage d'air peut être modifiée au choix à partir d'un fonctionnement par aspiration vers un fonctionnement par soufflage, et inversement,
le carter de guidage d'air (10) portant en outre, sur le côté frontal, des éléments de charnière (19), sur lesquels est articulée en pivotement une grille de guidage d'air, de telle sorte que ladite grille de guidage d'air peut pivoter entre une position de montage et une position de maintenance, ladite grille couvrant sur le côté frontal, dans la position de montage, une zone de passage d'air du carter de guidage d'air (10).

2. Unité de guidage d'air selon la revendication 1, **caractérisée en ce que** le module de ventilateur (30) comporte un raccord électrique (35), **en ce que** le module de ventilateur (30) peut être fixé dans plusieurs positions de montage sur le carter de guidage d'air (10), et le raccord électrique (35), dans les différentes positions de montage, est orienté par rapport au carter de guidage d'air dans des affectations différentes.

3. Unité de guidage d'air selon la revendication 1 ou 2, **caractérisée en ce que** le module de ventilateur (30) comporte un épaulement (39) circulaire qui est inséré dans une ouverture de passage (16) circulaire du carter de guidage d'air (10) et est centré dans celle-ci, et ledit épaulement (39) est apte à tourner dans l'ouverture de passage (16) pour permettre l'enclenchement de la saillie d'arrêt (23) dans le tronçon de blocage (32.2).

4. Unité de guidage d'air selon l'une quelconque des revendications 1 à 3, **caractérisée en ce que**, au moment de l'enclenchement du module de ventilateur (30), la pièce d'immobilisation (22) peut être déviée dans le sens opposé à la précontrainte d'un ressort (21), et la pièce d'immobilisation (22), dans la position de montage, s'enclenche dans un logement de blocage pour immobiliser le module de ventilateur (30).

5. Unité de guidage d'air selon l'une quelconque des revendications 1 à 4, **caractérisée en ce que**, dans la position de montage du module de ventilateur (30), la pièce d'immobilisation (22) peut être déplacée, au moyen d'un élément de déblocage (34), hors de la position d'immobilisation dans une position de déverrouillage.

6. Unité de guidage d'air selon l'une quelconque des revendications 1 à 5, **caractérisée en ce que** le carter de guidage d'air (10) comporte une paroi (11) périphérique qui est reliée d'un seul tenant à un fond (12), ledit fond (12) comportant l'ouverture de passage (16) pour l'air transporté par le module de ventilateur (30), et, dans la zone de la paroi (11), sur le côté extérieur, comporte des éléments de blocage (17) pour bloquer le carter de guidage d'air (10) dans une percée d'un élément mural.

7. Unité de guidage d'air selon l'une quelconque des revendications 1 à 4, **caractérisée en ce que** la saillie d'arrêt (23) est réalisée en forme de bouton et comporte une tige (23.2) munie d'une tête (23.1) au niveau de son extrémité libre, et le tronçon de blocage (32.2) est réalisé sous la forme d'un logement en fente, qui reçoit la tige (23.2) et est recouvert par la tête (23.1).
